# DEMANDE DE BREVET EUROPEEN

(11) **EP 2 017 879 A2**
(43) Date de publication de la demande: **21.01.2009**
(21) Numéro de dépôt: 08160591.7
(22) Date de dépôt: 17.07.2008
(51) Int. Cl.: H01L 21/033, H01L 21/308, H01L 21/265, H01L 21/266

(54) **Procédé de traitement de portions de parois d'une ouverture formée dans un substrat de silicium**

(30) Priorité: 18.07.2007 FR 0756571
(71) Demandeur: STMICROELECTRONICS SA, 92120 Montrouge (FR)
(72) Inventeur: Jeanne, Edgard, 37540 Saint Cyr sur Loire (FR); Nizou, Sylvain, 37210 Noizay (FR)
(74) Mandataire: de Beaumont, Michel

(57) **Abrégé**

L'invention concerne un procédé de traitement d'au moins une paroi d'une ouverture (3) formée dans un substrat de silicium (1), comprenant successivement les étapes suivantes :
(a) réaliser une implantation d'atomes de fluor dans une partie supérieure de la paroi de l'ouverture (3) ;
(b) procéder à une étape d'oxydation ; et
(c) appliquer un traitement spécifique sur au moins une portion de la partie non implantée de l'ouverture (3).

## Description

### Domaine de l'invention

La présente invention concerne des structures semiconductrices et, plus particulièrement, le traitement de zones localisées d'une ou plusieurs parois d'une ouverture ou tranchée formée dans un substrat semiconducteur.

### Exposé de l'art antérieur

Pour former des composants électroniques sur un substrat semiconducteur, il peut être nécessaire de créer, dans le substrat, une ou plusieurs ouvertures ou tranchées verticales qui peuvent être traversantes ou non traversantes. Ces ouvertures peuvent être ensuite traitées de diverses manières. Par exemple, les parois des ouvertures peuvent être fortement dopées. Les ouvertures peuvent également être remplies de matériaux isolants ou conducteurs, ou d'une alternance de couches isolantes et conductrices.

### Résumé de l'invention

On peut également souhaiter traiter, uniquement sur une certaine profondeur, une ou plusieurs parois d'une ouverture ou tranchée verticale, par exemple pour former des caissons enterrés fortement dopés ou pour réaliser une gravure à partir d'une partie d'une ou de plusieurs parois de l'ouverture.

On propose ici divers procédés permettant de réaliser un masque sur une ou plusieurs parois d'une ouverture formée dans un substrat semiconducteur, ce masque permettant de réaliser des implantations de dopants ou des gravures à une certaine profondeur sur la ou les parois de l'ouverture.

Ainsi, un mode de réalisation de la présente invention prévoit un procédé de traitement d'au moins une paroi d'une ouverture formée dans un substrat de silicium, comprenant successivement les étapes suivantes :
(a) réaliser une implantation d'atomes de fluor dans une partie supérieure de la paroi de l'ouverture ;
(b) procéder à une étape d'oxydation ; et
(c) appliquer un traitement spécifique sur au moins une portion de la partie non implantée de l'ouverture.

Selon un mode de réalisation de la présente invention, l'étape (a) est précédée des étapes suivantes :
former une couche d'oxyde sur la paroi de l'ouverture ;
réaliser une implantation de dopants dans la couche d'oxyde au niveau de la partie supérieure de la paroi et au niveau d'une partie intermédiaire de la paroi située sous la partie supérieure de la paroi, les dopants étant choisis dans le groupe comprenant le bore, le phosphore et l'arsenic ; et
enlever l'oxyde qui a été dopé au niveau des parties supérieure et intermédiaire de la paroi.

Selon un mode de réalisation de la présente invention, l'étape (c) consiste en une implantation de dopants dans la partie supérieure de la paroi et dans une partie intermédiaire de la paroi située sous la partie supérieure de la paroi, les dopants étant choisis dans le groupe comprenant le bore, le phosphore et l'arsenic.

Selon un mode de réalisation de la présente invention, l'étape (c) consiste à désoxyder au moins une partie intermédiaire de la paroi située sous la partie supérieure de la paroi puis à implanter des dopants dans la partie intermédiaire de la paroi, les dopants étant choisis dans le groupe comprenant le bore, le phosphore et l'arsenic.

Selon un mode de réalisation de la présente invention, l'étape (c) consiste à désoxyder au moins une partie intermédiaire de la paroi située sous la partie supérieure de la paroi puis à graver, dans l'ouverture, le substrat de silicium non protégé par de l'oxyde.

Selon un mode de réalisation de la présente invention, l'étape (c) est suivie d'une étape de désoxydation totale de l'ouverture.

Selon un mode de réalisation de la présente invention, les implantations de dopants et d'atomes de fluor sont des implantations obliques par rapport à la direction de l'ouverture.

Selon un mode de réalisation de la présente invention, l'ouverture ne traverse pas le substrat.

Un mode de réalisation de la présente invention prévoit un transistor à effet de champ vertical à jonction formé dans un substrat de silicium faiblement dopé de type N comprenant, dans la partie supérieure du substrat, une électrode de source en contact avec le substrat par l'intermédiaire d'une région de type N fortement dopée, et, dans la partie inférieure du substrat, une région de drain en contact avec le substrat par l'intermédiaire d'une région de type N fortement dopée, la région de source étant encadrée par des ouvertures remplies d'un conducteur connecté à la grille du transistor, les parois de ces ouvertures étant revêtues d'oxyde, à l'exception de zones profondes à partir desquelles s'étendent des zones dopées de type P.

Un mode de réalisation de la présente invention prévoit un support de cellule de pile à combustible en silicium comprenant des ouvertures verticales non traversantes et des ouvertures verticales traversantes, les extrémités supérieures des ouvertures non traversantes débouchant sur des parties actives de la pile à combustible et les extrémités supérieures des ouvertures traversantes débouchant sur des parties non-actives de la pile à combustible, des ouvertures horizontales étant formées en profondeur sur les parois des ouvertures verticales, ces ouvertures horizontales permettant de former des passages entre les ouvertures verticales.

### Brève description des dessins

Ces objets, caractéristiques et avantages, ainsi que d'autres seront exposés en détail dans la description suivante de modes de réalisation particuliers faite à titre non-limitatif en relation avec les figures jointes parmi lesquelles :
les figures 1A à 1D sont des vues en coupe illustrant des étapes successives d'un premier procédé de formation d'un caisson enterré fortement dopé s'étendant à partir des parois d'une ouverture formée dans un substrat de silicium ;
les figures 2C et 2D sont des vues en coupe illustrant une variante du procédé des figures 1A à 1D ;
les figures 3A et 3B sont des vues en coupe illustrant des étapes successives d'un procédé de gravure d'une partie des parois d'une ouverture formée dans un substrat de silicium ;
les figures 4A à 4G sont des vues en coupe illustrant des étapes successives d'un second procédé de formation d'un caisson enterré fortement dopé s'étendant à partir des parois d'une ouverture formée dans un substrat de silicium ;
les figures 5 et 6 illustrent des variantes du procédé des figures 4A à 4G ;
les figures 7A et 7B représentent un exemple d'application d'un procédé selon un mode de réalisation de la présente invention ;
la figure 8 illustre une cellule de pile à combustible connue ; et
les figures 9A et 9B représentent un autre exemple d'application d'un procédé selon un mode de réalisation de la présente invention.

Par souci de clarté, de mêmes éléments ont été désignés par de mêmes références aux différentes figures et, de plus, comme cela est habituel dans la représentation des structures semiconductrices, les diverses figures ne sont pas tracées à l'échelle.

### Description détaillée

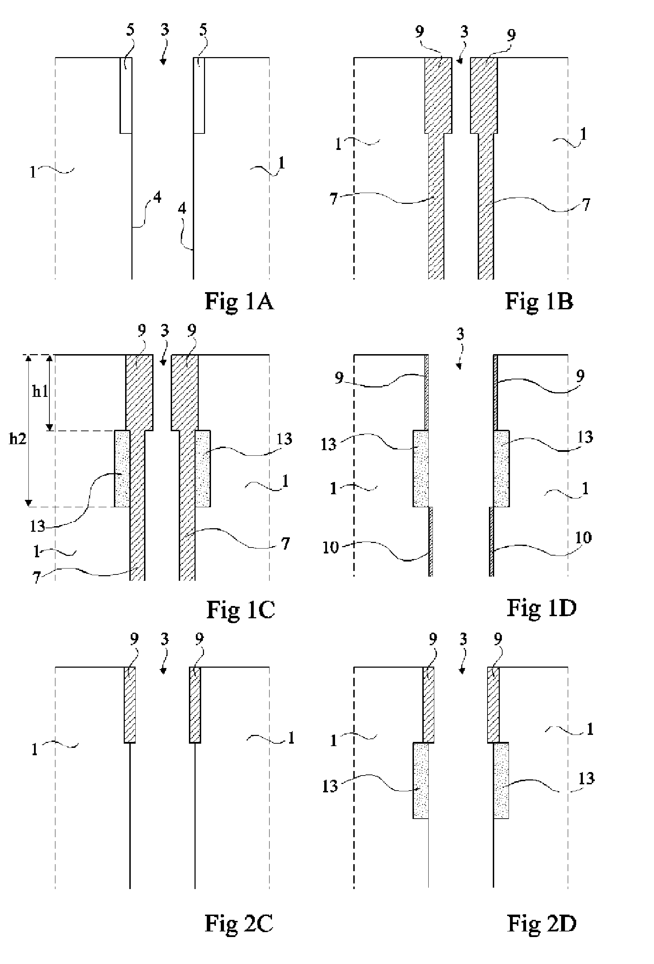

Les figures 1A à 1D sont des vues en coupe illustrant des étapes successives d'un procédé de formation d'un caisson enterré fortement dopé s'étendant à partir des parois d'une ouverture formée dans un substrat de silicium.

La figure 1A représente la partie supérieure d'un substrat de silicium 1. Dans ce substrat est formée une ouverture 3. Cette ouverture s'étend ou bien sur toute l'épaisseur du substrat ou bien seulement sur une profondeur limitée de celui-ci. Dans ce qui suit, on considérera que l'ouverture a la forme d'une tranchée rectiligne mais elle pourra bien entendu avoir toute forme souhaitée. Elle pourra par exemple avoir une section circulaire et/ou être constituée de portions de tranchées se rejoignant à des angles divers. Sur la partie supérieure de deux faces opposées 4 de l'ouverture 3, on a implanté des atomes de fluor 5. Les zones implantées 5 peuvent résulter de deux implantations obliques symétriques par rapport à la verticale. Si l'on souhaite implanter toute la périphérie de la région supérieure de l'ouverture 3, on pourra maintenir une implantation oblique tandis que l'on fait tourner le substrat sur un support.

La figure 1B représente la structure obtenue après avoir procédé à une étape d'oxydation thermique. Cette oxydation thermique entraîne que les flancs de l'ouverture sont oxydés sur une première épaisseur, aux emplacements 7 où l'ouverture n'a pas reçu d'implantation d'atomes de fluor, et sur une seconde épaisseur, aux emplacements 9 où l'ouverture a reçu une implantation d'atomes de fluor. La seconde épaisseur, dans les régions ayant reçu une implantation d'atomes de fluor, est supérieure à la première épaisseur. En figure 1B, on n'a pas représenté d'oxydation de la surface supérieure du substrat 1. Ceci suppose que l'oxydation thermique a été effectuée alors que cette surface était protégée, par exemple par une couche de nitrure de silicium. Cette protection peut également avoir servi à éviter l'implantation d'atomes de fluor dans la surface supérieure du substrat. Néanmoins, ceci ne constitue qu'une variante de l'invention et on pourra prévoir que la surface supérieure du substrat ait également reçu une implantation d'atomes de fluor et soit également oxydée sur une profondeur sensiblement égale à celle des régions 9.

A l'étape illustrée en figure 1C, on a réalisé une nouvelle implantation oblique mais cette fois-ci d'atomes d'un dopant. L'énergie d'implantation est choisie de sorte que les dopants implantés ne traversent pas les régions 9 d'oxyde de silicium épais. L'angle et l'énergie d'implantation sont choisis pour qu'on implante une région 13 à travers la couche d'oxyde plus mince 7 sur une profondeur limitée. Ainsi, après recuit, la zone implantée 13 s'étend sur une profondeur comprise entre la profondeur h1 de la région ayant subi l'implantation d'atomes de fluor et la profondeur h2 résultant de l'angle d'implantation choisi pour l'implantation oblique d'atomes dopants. A titre d'exemple, les atomes dopants pourront être des dopants de type P tels que du bore ou des dopants de type N tels que du phosphore ou de l'arsenic.

Comme l'illustre la figure 1D, on peut éventuellement prévoir ensuite une étape de désoxydation partielle de la structure pour, par exemple, éliminer complètement la couche d'oxyde 7 en laissant en place une partie de l'épaisseur de la couche d'oxyde 9. On comprendra que cette étape est optionnelle et dépend de l'utilisation que l'on veut faire du dispositif. A titre de variante, la durée de l'étape de désoxydation peut être calculée de sorte qu'il reste en place une région d'oxyde de silicium 10 dans l'ouverture 3 en dessous des régions implantées 13. En effet, de façon courante, un oxyde non dopé se grave moins vite qu'un oxyde dopé.

Les figures 2C et 2D illustrent une variante de réalisation du procédé décrit ci-dessus. On part de l'état de la structure telle que représentée en figure 1B mais, comme l'illustre la figure 2C, avant de réaliser l'implantation des régions dopées 13, on commence par effectuer une désoxydation partielle pour laisser en place seulement des régions d'oxyde supérieures 9 amincies et pour éliminer complètement, ou presque complètement, les parties d'oxyde plus profondes et plus minces 7. Ceci peut faciliter l'implantation des atomes dopants dans les régions 13.

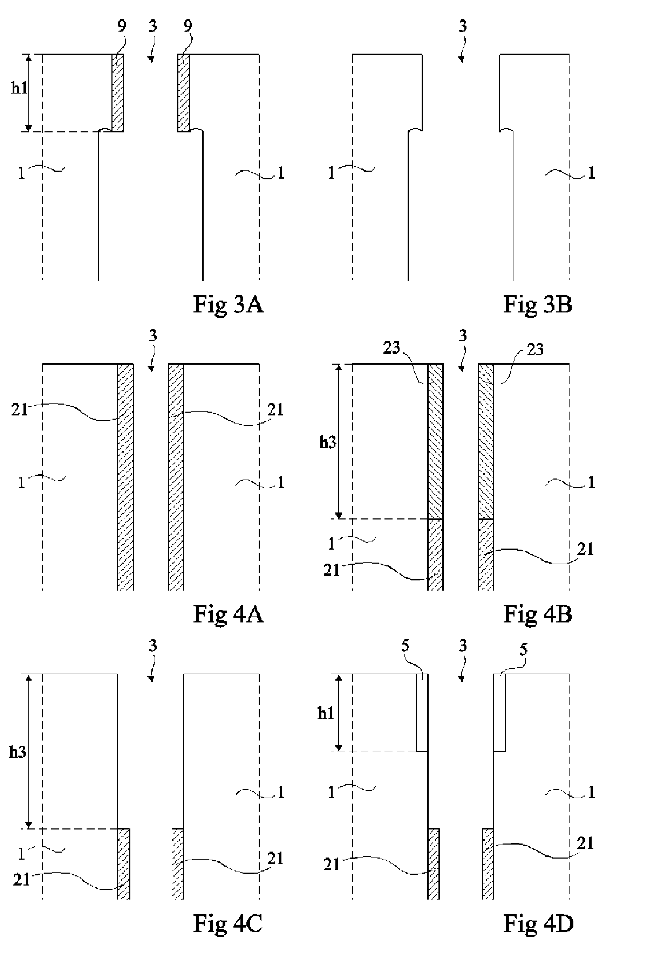

Les figures 3A et 3B sont deux vues en coupe illustrant une autre variante d'un procédé selon un mode de réalisation de la présente invention. On part par exemple de la structure illustrée en figure 2C et, au lieu de réaliser une implantation d'atomes dopants 13 sur une profondeur limitée de l'ouverture, on procède à une étape de gravure, par exemple une gravure isotrope. Cette gravure peut être une gravure plasma ou une gravure humide. On creuse ainsi, en dessous de la région protégée par l'oxyde 9, les parois de l'ouverture 3. La figure 3B représente une étape optionnelle qui peut suivre l'étape de la figure 3A. En figure 3B, on a représenté la structure après élimination des régions d'oxyde 9.

On notera que l'utilisation du procédé décrit en figures 3A et 3B entraîne que l'on grave les parois de l'ouverture ou tranchée sur toute la profondeur de celle-ci à partir de la profondeur h1 correspondant au fond de la région dans laquelle on a implanté les atomes de fluor.

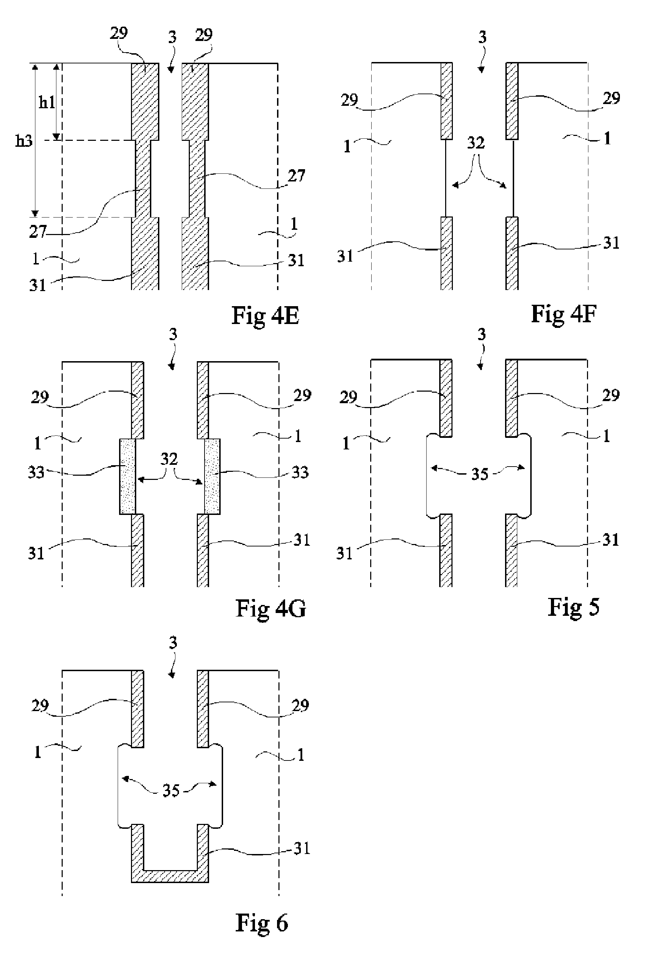

Les figures 4 à 6 illustrent diverses variantes d'un autre mode de réalisation du procédé décrit ici, dans lequel on cherche à effectuer un traitement sur une profondeur bien délimitée d'une ouverture, à une certaine profondeur par rapport à la surface supérieure du substrat dans lequel est formée l'ouverture.

La figure 4A est à nouveau une vue en coupe de la partie supérieure d'un substrat de silicium 1 dans lequel a été formée une ouverture ou tranchée 3. A l'étape illustrée en figure 4A, on a d'abord procédé à une oxydation thermique. Cette oxydation thermique entraîne la formation d'une couche d'oxyde de silicium 21 sur les parois de l'ouverture 3, et éventuellement, si celle-ci n'est pas protégée, une oxydation (non représentée) de la face supérieure du substrat de silicium 1.

A l'étape illustrée en figure 4B, on a procédé à une implantation oblique de la partie supérieure 23 de la couche d'oxyde 21 par des atomes dopants tels que les atomes de bore, de phosphore ou d'arsenic. Cette implantation est effectuée dans la partie supérieure de la couche d'oxyde, sur une profondeur h3. L'énergie d'implantation est choisie pour que les atomes dopants pénètrent dans la couche d'oxyde mais ne la traversent pas.

A l'étape illustrée en figure 4C, on a procédé à une gravure de l'oxyde de silicium. Cette gravure est limitée dans le temps, de façon à graver complètement la partie 23 de la couche d'oxyde qui a reçu des atomes dopants et à ne graver que partiellement la partie 21 de la couche d'oxyde qui n'a pas été implantée. Il résulte de cette étape que l'on obtient une ouverture dont toute la partie inférieure est revêtue d'une couche d'oxyde 21 et dont au moins une paroi de la partie supérieure a été dénudée de sorte que le silicium du substrat 1 est apparent. En figure 4C, on a représenté que les deux faces opposées de l'ouverture sont dénudées. Tout le contour de la partie supérieure de l'ouverture pourrait bien entendu être dénudé également, ou au contraire une seule paroi de cette ouverture pourrait être dénudée.

Après cela, à l'étape illustrée en figure 4D, on reprend le processus décrit en relation avec la figure 1. Ainsi, en figure 4D, on peut voir que l'on a implanté des atomes de fluor 5 dans la partie supérieure de l'ouverture sur une profondeur h1 inférieure à la profondeur h3. Cette implantation est représentée comme étant effectuée sur deux faces opposées de l'ouverture. De la même façon que cela a été décrit précédemment, elle pourra être réalisée sur tout le tour de l'ouverture ou sur une seule face de celle-ci.

En figure 4E, comme en figure 1B, on procède à une étape d'oxydation thermique. Il en résulte que la couche d'oxyde 21 dans la partie inférieure de l'ouverture s'épaissit pour fournir une couche d'oxyde 31, qu'une couche d'oxyde moins épaisse 27 se forme entre les profondeurs h1 et h3, et qu'une couche d'oxyde plus épaisse 29 se forme sur la profondeur h1.

A l'étape illustrée en figure 4F, on a procédé à une désoxydation partielle de la structure, de sorte que la couche d'oxyde la plus mince 27 est éliminée dans la zone désignée par la référence 32 tandis qu'une partie au moins des couches d'oxyde plus épaisses 29 et 31 reste en place.

A l'étape illustrée en figure 4G, on a formé une région dopée 33 au niveau de la zone 32, entre les profondeurs h1 et h3. Le dopage peut être effectué par tout moyen désiré dans le cas représenté où on a procédé préalablement à une désoxydation complète de la région concernée située entre les profondeurs h1 et h3. Ce dopage pourra par exemple résulter d'une diffusion à partir de silicium polycristallin dopé formé dans l'ouverture ou d'une diffusion réalisée à partir d'un prédépôt gazeux. Ce dopage pourra aussi être réalisé par implantation oblique, mais alors l'angle d'implantation n'a pas besoin d'être choisi avec soin puisque la zone à doper, 32, a été délimitée par les régions d'oxyde 29 et 31. On notera que, dans le cas d'une implantation oblique, l'implantation pourrait être réalisée à travers une mince couche d'oxyde restant en place dans la zone 32.

En figure 5, on a représenté qu'au lieu de doper la zone 32 de l'ouverture située entre les profondeurs h1 et h3, on peut procéder à une gravure pour former des évidements 35 s'étendant à partir de la zone 32.

Dans ce qui précède, on a énoncé que l'ouverture ou tranchée 3 pouvait s'étendre sur une grande profondeur à partir de la surface supérieure du substrat, et éventuellement sur toute l'épaisseur de ce substrat. L'ouverture ou tranchée 3 pourra également avoir une profondeur limitée, et ceci s'applique à toutes les variantes du procédé décrit précédemment.

La figure 6 représente le cas d'une ouverture de profondeur limitée en correspondance avec la structure illustrée en figure 5. Dans ce cas, de l'oxyde 31 tapisse les parois de l'ouverture sous la profondeur h3, comme en figure 5, mais le fond de l'ouverture est également oxydé.

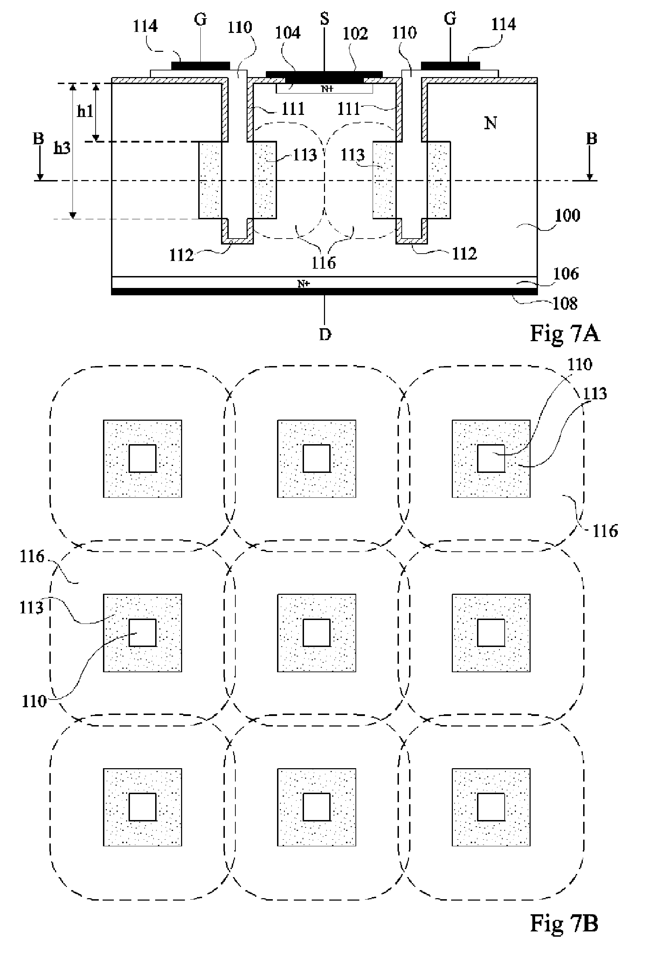

Les figures 7A et 7B représentent un exemple d'application du procédé décrit précédemment dans lequel on réalise des portions de couches dopées enterrées à partir d'au moins une paroi d'une ouverture.

Plus particulièrement, la figure 7A est une vue de côté en coupe et la figure 7B est une vue de dessus en coupe de cellules d'un transistor à effet de champ vertical à jonction (JFET). De multiples cellules sont formées dans un substrat de silicium 100 de type N. Chaque cellule comprend, du côté de sa surface supérieure, une électrode de source 102 en contact, par l'intermédiaire d'une région de type N plus fortement dopée 104, avec le substrat 100. Du côté de la face inférieure du substrat 100, s'étend une région fortement dopée de type N (N⁺) 106 ayant éventuellement, contrairement à ce qui est représenté, une épaisseur relativement importante, auquel cas le substrat 100 est en fait une couche épitaxiée formée sur cette région N⁺ 106. La région 106 est recouverte d'une métallisation de drain 108. La région de source est encadrée par des ouvertures 110 remplies d'un conducteur, par exemple du silicium polycristallin dopé. Conformément au procédé décrit précédemment, la partie supérieure de l'ouverture, sur une profondeur h1, est revêtue d'oxyde, et la partie inférieure de cette ouverture, au-delà d'une profondeur h3, est revêtue d'oxyde 112. Entre les profondeurs h1 et h3, des zones dopées 113 sont formées. Ces zones dopées résultent par exemple d'une diffusion d'atomes dopants à partir du silicium polycristallin fortement dopé remplissant les ouvertures 110. Des métallisations de grille 114 sont en contact avec le conducteur remplissant les ouvertures 110. Dans un premier état, où la grille n'est pas polarisée, il n'existe pas de conduction à travers la région N 100 entre les régions de source 104 et de drain 106. Par contre, lorsque la grille est convenablement polarisée, l'amincissement des zones déplétées 113 autorise la circulation des charges. C'est là le fonctionnement classique d'un transistor JFET dit "Normally OFF" ou à "fonctionnement normal non passant". On notera que la structure est réalisée de façon particulièrement simple grâce au procédé décrit précédemment.

La figure 7B est une vue de dessus en coupe selon le plan de coupe B-B de la figure 7A. On y voit un ensemble de cellules identiques à celle de la figure 7A.

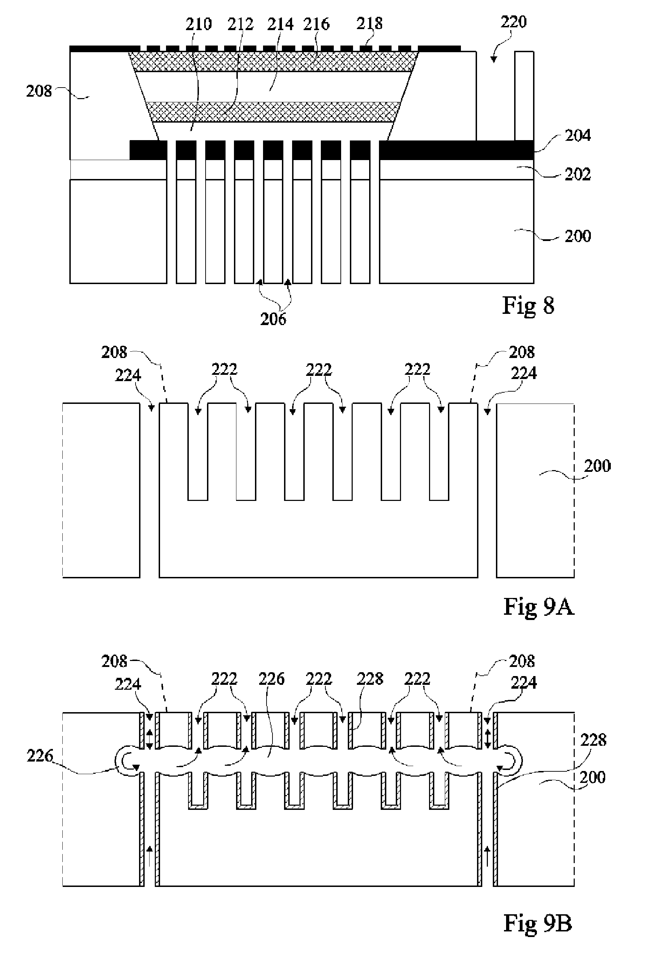

La figure 8 illustre une cellule de pile à combustible intégrée. Sur un support de silicium 200 est formée une couche isolante 202 surmontée d'une couche conductrice 204 formant le collecteur d'anode de la pile à combustible. Des ouvertures traversantes 206 sont formées dans le support de silicium 200, la couche isolante 202 et la couche conductrice de collecteur d'anode 204. Sur la couche conductrice 204 est formée une couche isolante épaisse 208. Dans chacune de plusieurs ouvertures formées dans la couche 208 est formé un empilement d'un support de catalyseur 210, d'une première couche de catalyseur 212, d'une couche d'électrolyte 214 et d'une seconde couche de catalyseur 216, la couche de catalyseur 216 affleurant la face supérieure de la couche isolante 208. Au-dessus de la seconde couche de catalyseur 216 est formée une couche conductrice de collecteur de cathode 218 qui comporte des ouvertures traversantes sur toute sa surface. Dans la couche isolante 208 est formée une ouverture 220 permettant le contact avec la couche conductrice de collecteur d'anode 204.

Pour faire fonctionner la cellule de pile à combustible, on injecte de l'hydrogène dans les ouvertures 206 du support 200. L'hydrogène est "décomposé" au niveau de la couche de catalyseur 212 pour former, d'une part, des protons H⁺ qui se dirigent vers la couche d'électrolyte 214 et, d'autre part, des électrons qui se dirigent vers le collecteur d'anode 204. Les protons H⁺ traversent la couche d'électrolyte 214 jusqu'à rejoindre la couche de catalyseur 216. La couche 216 est en contact avec de l'oxygène, par exemple l'air ambiant, et les protons H⁺ se recombinent avec l'oxygène. Il en résulte l'apparition d'une différence de potentiel entre anode et cathode.

Les figures 9A et 9B illustrent des étapes de formation d'un support 200 de cellule de pile à combustible selon un mode de réalisation de la présente invention. Des lignes en pointillés 208 indiquent les limites de l'empilement du support de catalyseur 210, de la première couche de catalyseur 212, de la couche d'électrolyte 214 et de la seconde couche de catalyseur 216.

A l'étape illustrée en figure 9A, des ouvertures 222 non traversantes sont formées dans le support 200. Des ouvertures traversantes 224 sont formées de part et d'autre des ouvertures non traversantes 222 dans le support 200 pour permettre l'alimentation en hydrogène de la cellule de pile à combustible. Les lignes en pointillés 208 illustrent le fait que l'empilement actif de la pile est formé au niveau des ouvertures non traversantes 222 mais ne s'étend pas au niveau des ouvertures traversantes 224. En d'autres termes, les ouvertures traversantes 224 débouchent en regard de la couche isolante épaisse 208 de la figure 8.

A l'étape illustrée en figure 9B, on a appliqué le procédé décrit précédemment en relation avec les figures 4A à 4F et 5 aux ouvertures 222 et 224. On forme ainsi, sur une profondeur désirée du support 200, des ouvertures horizontales 226 de chaque côté des ouvertures 222 et 224, les ouvertures horizontales 226 se rejoignant entre les ouvertures verticales 222 et 224. En figure 9B, une couche d'oxyde 228 est présente sur les parois des ouvertures verticales 222 et 224. Cette couche 228 peut être enlevée, si désiré, une fois les ouvertures horizontales 226 formées.

La structure de la figure 9B a l'avantage d'éviter que l'hydrogène ne soit directement envoyé sur la couche de catalyseur 212. En effet, comme cela est représenté par des flèches en figure 9B, l'hydrogène arrivant dans les ouvertures 224 passe dans les ouvertures horizontales 226 puis dans les ouvertures verticales 222 pour atteindre la couche de catalyseur 212. Ceci permet de réguler les pics de pression de l'hydrogène arrivant sur la couche de catalyseur 212, par exemple aux moments où on ouvre une bouteille d'hydrogène. On élimine ainsi un risque de décollement de l'empilement actif de la cellule de pile à combustible.

Des modes de réalisation particuliers de la présente invention ont été décrits. Diverses variantes et modifications apparaîtront à l'homme de l'art. En particulier, il est possible de former plusieurs zones spécifiques sur les parois d'ouvertures formées dans un substrat de silicium. En effet, une fois une première zone traitée sur les parois de l'ouverture, il est possible de répéter le procédé décrit en relation avec les figures 4A à 4F pour obtenir un second masque permettant de traiter une autre zone des parois. A l'étape de la figure 4B, l'implantation de dopants sera réalisée sur une profondeur adaptée. De plus, il est possible de réaliser, sur une même paroi, des traitements différents. Par exemple, il est possible de réaliser une gravure sur une portion de la ou des parois et de former un caisson fortement dopé sur une autre portion de la ou des parois.

## Revendications

1. Procédé de traitement d'au moins une paroi d'une ouverture (3) formée dans un substrat de silicium (1), comprenant successivement les étapes suivantes :
(a) réaliser une implantation d'atomes de fluor (5) dans une partie supérieure de la paroi de l'ouverture (3) ;
(b) procéder à une étape d'oxydation ; et
(c) graver au moins une portion de la partie non implantée de l'ouverture (3) ou y implanter des dopants.

2. Procédé selon la revendication 1, dans lequel l'étape (a) est précédée des étapes suivantes :
former une couche d'oxyde (21) sur la paroi de l'ouverture (3) ;
réaliser une implantation de dopants (23) dans la couche d'oxyde (21) au niveau de ladite partie supérieure de la paroi et au niveau d'une partie intermédiaire de la paroi située sous la partie supérieure de la paroi, les dopants étant choisis dans le groupe comprenant le bore, le phosphore et l'arsenic ; et
enlever l'oxyde qui a été dopé (23) au niveau des parties supérieure et intermédiaire de la paroi.

3. Procédé selon la revendication 1 ou 2, dans lequel l'étape (c) consiste en une implantation de dopants dans ladite partie supérieure de la paroi et dans une partie intermédiaire de la paroi située sous la partie supérieure de la paroi, les dopants étant choisis dans le groupe comprenant le bore, le phosphore et l'arsenic.

4. Procédé selon la revendication 1 ou 2, dans lequel l'étape (c) consiste à désoxyder au moins une partie intermédiaire de la paroi située sous ladite partie supérieure de la paroi puis à implanter des dopants dans la partie intermédiaire de la paroi, les dopants étant choisis dans le groupe comprenant le bore, le phosphore et l'arsenic.

5. Procédé selon la revendication 1 ou 2, dans lequel l'étape (c) consiste à désoxyder au moins une partie intermédiaire de la paroi située sous ladite partie supérieure de la paroi puis à graver, dans l'ouverture (3), le substrat de silicium non protégé par de l'oxyde.

6. Procédé selon la revendication 1, dans lequel l'étape (c) est suivie d'une étape de désoxydation totale de l'ouverture (3).

7. Procédé selon la revendication 1, dans lequel les implantations de dopants et d'atomes de fluor sont des implantations obliques par rapport à la direction de l'ouverture (3).

8. Procédé selon la revendication 1, dans lequel l'ouverture (3) ne traverse pas le substrat (1).

9. Transistor à effet de champ vertical à jonction formé dans un substrat de silicium (100) faiblement dopé de type N comprenant, dans la partie supérieure du substrat, une électrode de source (102) en contact avec le substrat par l'intermédiaire d'une région de type N fortement dopée (104), et, dans la partie inférieure du substrat, une région de drain (108) en contact avec le substrat par l'intermédiaire d'une région de type N fortement dopée (106), la région de source étant encadrée par des ouvertures (110) remplies d'un conducteur connecté à la grille du transistor, les parois de ces ouvertures étant revêtues d'oxyde (111, 112), à l'exception de zones profondes à partir desquelles s'étendent des zones dopées de type P (113), lesdites zones dopées de type P étant formées conformément au procédé de la revendication 1.

10. Support de cellule de pile à combustible (200) en silicium comprenant des ouvertures verticales non traversantes (222) et des ouvertures verticales traversantes (224), les extrémités supérieures des ouvertures non traversantes (222) débouchant sur des parties actives de la pile à combustible et les extrémités supérieures des ouvertures traversantes (224) débouchant sur des parties non-actives de la pile à combustible, des ouvertures horizontales (226) étant formées, conformément au procédé selon les revendications 1, 2 et 5, en profondeur sur les parois des ouvertures verticales (222, 224), ces ouvertures horizontales (226) permettant de former des passages entre les ouvertures verticales (222, 224).
